# EUROPEAN PATENT SPECIFICATION

(11) **EP 1 899 788 B1**
(45) Date of publication and mention of the grant of the patent: **31.03.2010**
(21) Application number: 05769529.8
(22) Date of filing: 23.06.2005
(51) Int. Cl.: G06F 1/20, H05K 7/20

(54) **AIR CONDITIONING SYSTEM FOR RACK CABINETS**
KLIMAANLAGENSYSTEM FÜR RACK-GEHÄUSE
SYSTEME DE CLIMATISATION POUR ARMOIRES

(43) Date of publication of application: 19.03.2008
(73) Proprietor: Stulz S.p.a., 37067 Valeggio s/M (IT)
(72) Inventor: PEROTTI, Paolo, I-37019 Peschiera d/G (IT)
(74) Representative: Petraz, Gilberto Luigi
(86) International application number: PCT/IT2005/000363
(87) International publication number: WO 2006/137091

(56) References cited:
- WO-A-2004/051445
- US-A1- 2004 020 224
- US-A1- 2005 126 747
- US-B1- 6 167 947

## Description

### TECHNICAL FIELD

The present invention concerns a system for conditioning rack cabinets of the type used to house electrical and electronic components subject to overheating.

In particular the present invention refers to a conditioning system that uses a refrigerant gas as the sole heat exchange medium and where this gas is circulated in a system consisting simply of a remote condenser unit housing the heat exchanger coil and the inverter compressor.

In other words, the system is designed to use the principle of direct expansion and can therefore practically dispense with the need for water, the medium most widely used to cool rack cabinets and other items of electronic equipment.

The invention enables an improvement in rack cooling and in comparison with known solutions is a much more efficient and economic method for cooling components inside the rack cabinet; this solution limits energy consumption as much as possible while maintaining high performance levels.

The invention is intended for the electromechanical engineering industry and in particular for the sector involved in the manufacture of equipment for cooling racks and electrical cabinets in general.

### BACKGROUND ART

The technology involved in electrical cabinets and rack cabinets is well-known; such cabinets are containers of various sizes housing various electrical and electronic components subject to overheating. These components must be cooled by special heat exchangers designed to cool the interior of the cabinets and thus prevent damage to the components housed therein.

Rack cabinets are usually housed inside data centres, controlled atmosphere environments where temperature and humidity parameters are constantly monitored. Data centre environments can house any number of rack units ranging from a few units up to a hundred rack cabinets.

The components inside rack cabinets give off energy in the form of heat. In order to ensure efficient functioning of these components it is necessary to eliminate this energy by means of cooling systems.

In recent years it has been necessary to increase the performance of rack cooling systems to keep pace with the considerable increase, in recent years, in the energy emitted by electronic components following the introduction of increasingly more powerful CPUs which now perform millions of operations per second.

The performance of a cooling system used in a data centre is calculated on the basis of the number components installed in each cabinet and the number of cabinets present in the data centre.

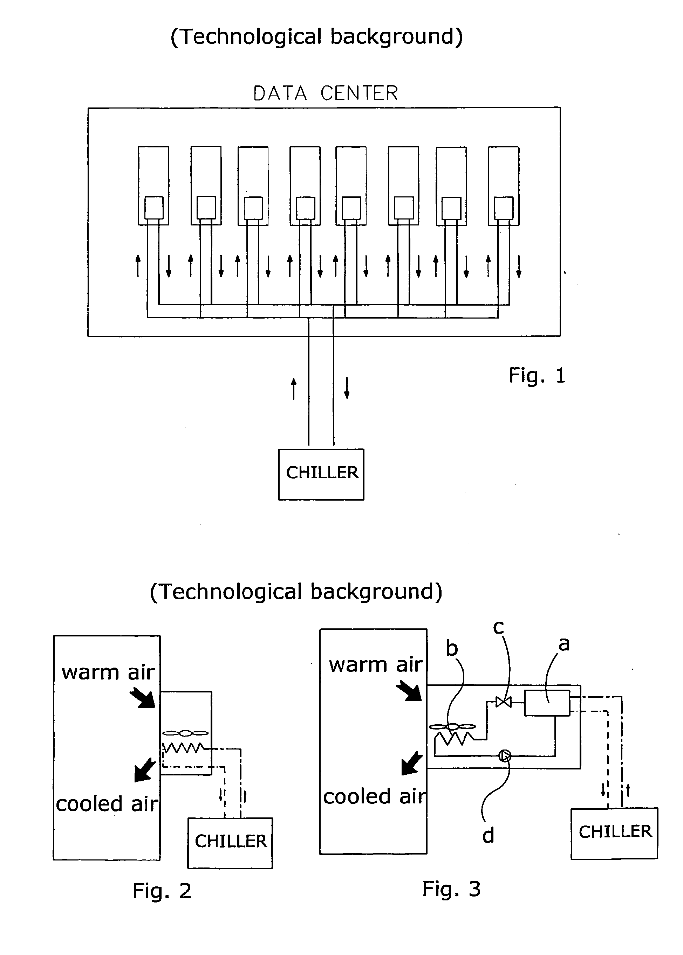

To date, the different types of conditioning systems used in data centres are as follows:
a) Forced ventilation system. This consists of a unit mounted on the back, door or roof of the rack cabinet and where the unit consists of one or more fans (usually of the radial type) which force the air inside the cabinet to circulate and prevent it from stagnating; this type of system is mainly used where the heating power produced is not very high;
b) System applied directly to the cabinet. In this case a conventional conditioner (that is of the direct expansion type) is installed inside the cabinet or on the side walls of the cabinet; This type dissipates a greater amount of heat than the previous type described above. Once again, however, in those cases where multiple cabinets require cooling, each cabinet must have its own, individual, independent cooling system;
c) Centralised system using a chiller, that is, an external fluid refrigeration unit. This type can dissipate a considerable amount of heat and has the undoubted advantage that it is possible to centralise the conditioning system. This type consists of a unit in a remote location (on the roof of a building or, in any case, in an environment outside the data centre) cooling multiple cabinets with chilled water (see Figure 1).

The individual units designed to exchange heat with the cabinet environment are:
■ Simple air/water exchangers. Here, the cooled water coming from the chiller is passed through a heat exchanger consisting of a coil made of copper tubes with aluminium fins. The hot air from the cabinet is circulated over the fins with the result that the air is cooled and the water in the coil is heated before being returned to the external chiller to be cooled once again (see Fig. 2). This type is used for power ratings up to 4/5 Kw.
■ Water condensing conditioners. These systems use refrigerant gas as the heat exchange medium where the gas completes a cooling cycle (see Fig. 3) by first condensing inside a condenser (a) where the heat is exchanged with the cooled water and then evaporated in a special coil (b), an evaporator, thus cooling the air from the cabinet. This system includes an expansion valve (c) and a compressor (d). This system type clearly has higher performance levels than the previous type and can dissipate considerable amounts of energy (up to 7/8 Kw).

Conventional chillers of the type normally installed (also in domestic applications) can reach very high power ratings (up to 150/200 Kw) and are therefore quite clearly in a position to cool a large number of units.

One of the main drawbacks in using these systems is the presence of water inside the cabinet or in close proximity to the cabinet and therefore in direct contact with the electronic equipment. A system malfunction or the leakage of water from the hydraulic equipment can cause irreparable damage to the equipment and electrical systems being cooled.

Document WO 2004/051445 discloses a system and method for cooling a room configured to house a plurality of computer systems, where a plurality of evaporator units are arranged in series and configured to receive air from the room and to deliver air to the room. The evaporator units are supplied with refrigerant operable to cool the received air in the evaporator units. At least one of the temperature of the refrigerant supplied to the evaporator units and the air delivery to the room may be controlled in response to temperature sensed at one or more locations in the room.

### DISCLOSURE OF THE INVENTION

The present invention aims to avoid the typical drawbacks and disadvantages of the known technology by providing a conditioning system for cooling electrical cabinets where the chiller unit employs a direct expansion system but does not use water as a heat exchange medium and is suitable for cooling multiple rack cabinets. The aim of the invention is also to provide a very efficient cooling system for the electrical components inside the cabinet.

The main advantage of this solution is the complete absence of water in the equipment to be cooled. This means that all the possible faults caused by water leaks, which it is known can cause irreparable damage to electronic equipment and systems, are totally eliminated.

The aims of the invention are achieved by means of a rack conditioning system with the characteristics described in the main claims.

The dependent claims describe particularly advantageous embodiments of the invention.

The main characteristic of the conditioning system described in the invention is the use of refrigerant gas (for example, R410a) as the sole heat exchange medium where this gas is circulated in a hydraulic system consisting of a remote condenser unit.

The remote condenser unit contains the heat exchanger coil and the inverter compressor and can serve multiple evaporation units applied directly to cabinets; the evaporators house the evaporator coil and the electronic expansion valve.

The conditioning system designed according to this invention has numerous advantages including the following:
■ a very high cooling capacity (18/20 Kw) for single cabinets;
■ greater efficiency in comparison with a system using direct expansion and a chiller;
■ possibility of fine adjusting the heat exchange process and thus optimising the absorption of electrical energy;
■ possibility of connecting multiple evaporator units to the same power condenser unit;
■ no risk of damage to electronic equipment; in the event of leaks from the cooling system, the gas evaporates and will not cause any damage to the equipment.

### BRIEF DESCRIPTION OF THE DRAWINGS

Further characteristics and advantages of the invention are apparent from the detailed description which follows and from the accompanying drawings which illustrate an embodiment of the invention provided merely by way of example without limiting the scope of the inventive step, and in which:
- Figures 1 to 3 show diagrammatic views of conventional rack cooling systems;
- Figure 4 shows a diagram of the rack conditioning system functional principle according to the invention;

### DETAILED DESCRIPTION OF AN EMBODIMENT OF THE INVENTION

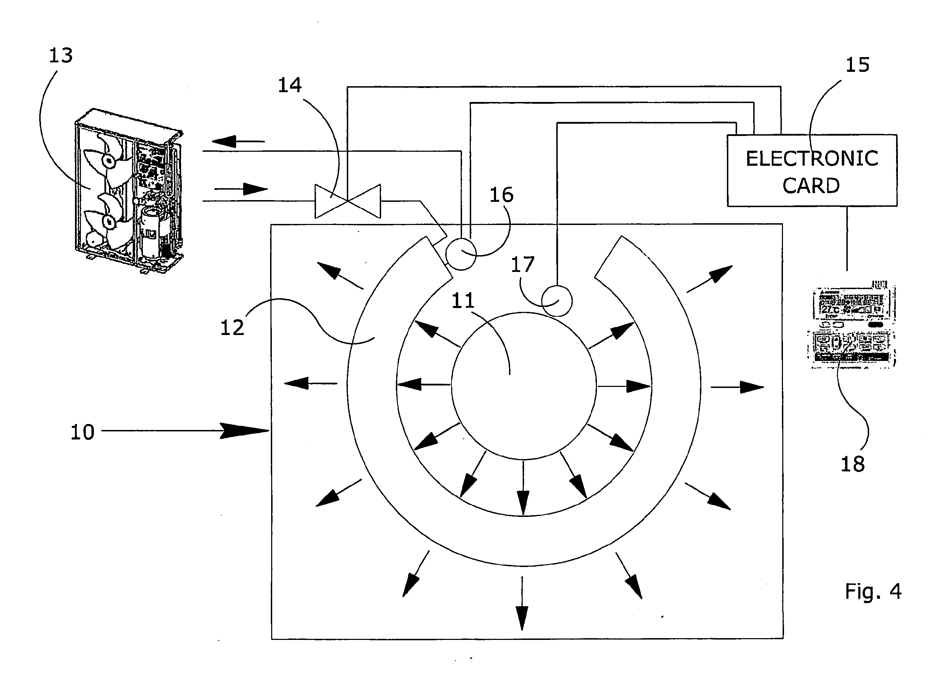

In Figure 4 the reference number 10 indicates a rack conditioning unit comprising substantially a centrifugal fan 11 and an evaporator 12 constructed in accordance with the design of direct expansion systems.

The conditioning unit 10 is directly applied to rack cabinets, that is, cabinets specifically designed to house electronic components and assemblies and in some cases installed in series with other racks units all sharing the same cooling source.

The principle feature of the conditioning system according to this invention is the use of a refrigerant gas (for example, R410a) as the sole heat exchange medium circulated in the system hydraulic equipment.

The refrigerant gas totally substitutes the water, the medium widely used in conventional systems for cooling multiple units, and thus eliminates related problems and increases system performance.

The hydraulic equipment according to the invention comprises a remote condenser unit 13 containing the heat exchanger coil and the inverter compressor able to supply multiple evaporator units 10 directly applied to cabinets and where the evaporator units house an evaporation coil 12 and an electronic expansion valve 14.

An electronic card 15 detects, by means of an extractor temperature sensor 16 and an overheating sensor 17, the temperature of the cabinet and the overheating temperature of the refrigerant fluid.

On the basis of these two parameters and the temperature set point set by the user on a special interface consisting of a display 18, the system "self-regulates" by automatically opening and closing the expansion valve and varying the speed of the inverter compressor.

The inverter regulates the frequency of the electrical power supply and therefore the rotary speed of the compressor in order to match the variations in cooling requirements which occur during operation.

This application has only been made possible by the introduction of inverter compressors with high cooling capacities on power condenser compressors with power ratings reaching 140/150 Kw.

The advantages of this application are:
a) a very high cooling capacity (18/20 Kw) for single cabinets;
b) greater efficiency in comparison with a system using direct expansion and a chiller;
c) possibility of fine adjusting the heat exchange process and thus optimising the absorption of electrical energy;
d) possibility of connecting multiple evaporator units to the same power condenser unit;
e) the complete absence of water in the hydraulic equipment of the system and consequently the complete elimination of the risk of damage to the electronic equipment caused by leaks and short-circuits; in the event of leaks from the cooling system the gas evaporates and will not cause any damage to the equipment.

In addition to its principle use for cooling rack cabinets, the system described can be advantageously used to cool any other unit or assembly of units subject to overheating in both the domestic and industrial sectors.

The invention described above refers to a preferred embodiment. The invention described here may be subject to modifications and variations without thereby departing from the scope of the inventive concept; all the details of the invention may be substituted by technically equivalent elements.

## Claims

1. A system for conditioning rack cabinets of the type used to house electrical, electronic and similar components subject to overheating, comprising hydraulic equipment designed to connect a chiller to a cool air distributor, comprising a remote condenser unit (13) containing a heat exchanger coil and an inverter compressor able to supply multiple evaporation units (10), whereby this hydraulic equipment uses a refrigerant gas as the sole heat exchange medium, **characterised in that** said multiple evaporator units (10) are directly applied to said rack cabinets, and **in that** the gas is circulated in the equipment starting from the remote condenser unit (13).

2. A conditioning system for rack cabinets according to claim 1, **characterised in that** each evaporator unit (10) houses an evaporation coil (12) and an electronic expansion valve (14).

3. A conditioning system for rack cabinets according to one of foregoing claims, **characterised in that** there is an electronic card (15) detecting, by means of an extractor temperature sensor (16) and an overheating sensor (17), the temperature of the cabinet and the overheating temperature of the refrigerant fluid.

4. A conditioning system for rack cabinets according to one of foregoing claims, **characterised in that** there is a user interface or controller unit (18) whereby, on the basis of the two parameters supplied by the extractor temperature sensor (16) and by the overheating sensor (17), and on the basis of the temperature set point set by the user on the user interface (18), the system "self-regulates" by automatically opening and closing the expansion valve and varying the speed of the inverter compressor.

5. A conditioning system for rack cabinets according to one of foregoing claims, **characterised in that** the inverter regulates the frequency of the electrical power supply and therefore the rotary speed of the compressor in order to match the variations in cooling requirements which occur during operation.

6. A conditioning system for rack cabinets according to one of foregoing claims, **characterised in that** the refrigerant gas being used as the sole heat exchange medium in the system consists of gas employed in refrigeration processes.

7. A conditioning system for rack cabinets according to one of foregoing claims, **characterised in that** the refrigerant gas being used as the sole heat exchange medium in the system is R410a type gas.

## Patentansprüche

1. Klimaanlagensystem für Rack-Gehäuse des Typs, der eingesetzt wird, um elektrische, elektronische und ähnliche Komponenten aufzunehmen, die einer Überhitzung ausgesetzt sind, mit einer hydraulischen Ausrüstung, die derart vorgesehen ist, dass sie einen Kühlapparat mit einem Verteiler für kalte Luft verbindet, mit einer entfernt angeordneten Kondensoreinheit (13), die eine Wärmetauscherwicklung und einen Inverterkompressor enthält, die dazu in der Lage sind, mehrere Verdampfereinheiten (10) zu versorgen, wobei diese hydraulische Ausrüstung ein Kältegas als das einzige Wärmetauschmedium einsetzt, **dadurch gekennzeichnet, dass** die mehreren Verdampfereinheiten (10) direkt den Rack-Gehäusen zugeordnet sind, und dass das Gas in der Ausrüstung zirkuliert wird, ausgehend von der entfernt angeordneten Kondensoreinheit (13).

2. Klimaanlagensystem für Rack-Gehäuse nach dem Anspruch 1, **dadurch gekennzeichnet, dass** jede Verdampfereinheit (10) eine Verdampferwicklung (12) und ein elektronisches Expansionsventil (14) aufnimmt.

3. Klimaanlagensystem für Rack-Gehäuse nach einem der vorhergehenden Ansprüche, **dadurch gekennzeichnet, dass** eine elektronische Karte (15) vorgesehen ist, die mittels eines Extraktor-Temperatursensors (16) und mittels eines Überhitzungssensors (17) die Temperatur des Gehäuses und die Überhitzungstemperatur des Kältemittelfluids erfasst.

4. Klimaanlagensystem für Rack-Gehäuse nach einem der vorhergehenden Ansprüche, **dadurch gekennzeichnet, dass** eine Benutzerschnittstelle oder eine Steuerungseinhit (18) vorgesehen ist, wobei, basierend auf den beiden Parametern, die von dem Extraktor-Temperatursensor (16) und von dem Überhitzungssensor (17) zur Verfügung gestellt werden, sowie auf der Basis eines festgelegten Temperaturwertes, der durch den Benutzer mittels der Benutzerschnittstelle (18) festgesetzt wird, das System durch automatisches Öffnen und Schließen des Expansionsventils und durch Veränderung der Drehzahl des inverterkompressors "selbstregulierend" arbeitet.

5. Klimaanlagensystem für Rack-Gehäuse nach einem der vorhergehenden Ansprüche, **dadurch gekennzeichnet, dass** der Inverter die Frequenz der elektrischen Stromversorgung reguliert und dadurch die Drehzahl des Kompressors, um eine Anpassung an unterschiedliche Kühlerfordernisse vorzunehmen, die während des Betriebs auftreten.

6. Klimaanlagensystem für Rack-Gehäuse nach einem der vorhergehenden Ansprüche, **dadurch gekennzeichnet, dass** das Kältemittelgas, welches als das einzige Wärmetauschmedium in dem System eingesetzt wird, aus einem Gas besteht, welches bei Kältetechnikprozessen eingesetzt wird.

7. Klimaanlagensystem für Rack-Gehäuse nach einem der vorhergehenden Ansprüche, **dadurch gekennzeichnet, dass** das Kältemittelgas, welches als das einzige Wärmetauschmedium in dem System eingesetzt wird, vom R410a-Typ ist.

## Revendications

1. Système de climatisation d'armoires pour coffrets du type utilisé pour loger des composants électriques, électroniques et similaires susceptibles de surchauffer, le système de climatisation comprenant un équipement hydraulique destiné à raccorder un compresseur frigorifique à un distributeur d'air froid et une unité distante formant condenseur (13) contenant une bobine d'échange de chaleur et un compresseur inverseur apte à alimenter de multiples unités d'évaporation (10), cet équipement hydraulique utilisant un gaz réfrigérant comme seul fluide d'échange de chaleur, **caractérisé en ce que** lesdites multiples unités formant évaporateur (10) sont directement montées sur lesdites armoires pour coffrets, et **en ce que** le gaz est mis en circulation dans l'équipement depuis l'unité distante formant condenseur (13).

2. Système de climatisation d'armoires pour coffrets selon la revendication 1, **caractérisé en ce que** chaque unité formant évaporateur (10) loge une bobine d'évaporation (12) et un clapet d'expansion électronique (14).

3. Système de climatisation d'armoires pour coffrets selon l'une des revendications précédentes, **caractérisé en ce qu'**il est prévu une carte électronique (15) détectant la température de l'armoire et la température de surchauffe du fluide réfrigérant au moyen d'un capteur de température d'extracteur (16) et d'un capteur de surchauffe (17).

4. Système de climatisation d'armoires pour coffrets selon l'une des revendications précédentes, **caractérisé en ce qu'**il est prévu une interface utilisateur ou une unité de commande (18), le système effectuant une « autorégulation » en ouvrant et fermant automatiquement le clapet d'expansion et modifiant la vitesse du compresseur inverseur à partir des deux paramètres fournis par le capteur de température d'extracteur (16) et par le capteur de surchauffe (17), et à partir du point de réglage de température fixé par l'utilisateur via l'interface utilisateur (18).

5. Système de climatisation d'armoires pour coffrets selon l'une des revendications précédentes, **caractérisé en ce que** l'inverseur règle la fréquence de l'alimentation électrique et donc la vitesse de rotation du compresseur afin d'adapter les variations aux exigences de refroidissement qui surviennent en cours de fonctionnement.

6. Système de climatisation d'armoires pour coffrets selon l'une des revendications précédentes, **caractérisé en ce que** le gaz réfrigérant utilisé comme seul fluide d'échange de chaleur dans le système consiste en un gaz employé dans des processus de réfrigération.

7. Système de conditionnement d'armoires pour coffrets selon l'une des revendications précédentes, **caractérisé en ce que** le gaz réfrigérant utilisé comme seul fluide d'échange de chaleur dans le système est un gaz de type R410a.
